# FASCICULE DE BREVET EUROPEEN

(11) **EP 0 309 301 B1**
(45) Date de publication et mention de la délivrance du brevet: **08.09.1993**
(21) Numéro de dépôt: 88401344.2
(22) Date de dépôt: 03.06.1988
(51) Int. Cl.: H03M 11/00, G06F 3/02

(54) **Procédé et dispositif d'analyse par un microprocesseur des états d'un panneau de commande**
Fernsteuerungsgerät für einen mit einem Videobildschirm vereinigten Rechner
Remote control apparatus for a computer associated with a video screen

(30) Priorité: 05.06.1987 FR 8707943
(43) Date de publication de la demande: 29.03.1989
(73) Titulaire: THOMSON-CSF, 75008 Paris (FR)
(72) Inventeur: Le Moulec, Patrick Thomson-CSF-SCPI, F-75008 Paris (FR); Galland, Jacques Thomson-CSF-SCPI, F-75008 Paris (FR)
(74) Mandataire: Lincot, Georges

(56) Documents cités:
- EP-A- 0 072 471
- DE-A- 2 616 648
- IBM TECHNICAL DISCLOSURE BULLETIN, vol. 29, no. 2, juillet 1986, pages 654-656, New York, US; "Method to provide low-cost keyboard support"

## Description

La présente invention concerne un procédé et un dispositif d'analyse par un microprocesseur des états d'un panneau de commande, ce dernier étant du type comprenant un ensemble clavier-commutateur et un écran d'affichage.

Dans les architectures connues à microprocesseur, l'analyse de l'état des unités périphériques est effectuée des manières décrites par exemple dans la demande de brevet européen EP 0.072.471 ou encore dans l'article intitulé "Method to provide low cost keyboard support" publié dans la revue IBM Technical Disclosure Bulletin, vol. 29 n^{o} 2 July 1986 pages 654-656 au moyen de signaux d'interrogation qui sont émis périodiquement par un microprocesseur à destination de chaque unité. C'est le cas par exemple des ensembles claviers-commutateurs de certains apparelis émetteurs-récepteurs radio où les fréquences et les modes de fonctionnement sont affichés au moyen d'un clavier ou de commutateurs et sont lus périodiquement par un microprocesseur. Cependant ce procédé est souvent la cause de perturbations électriques qui se manifestent sous la forme d'impulsions qui nuisent au bon fonctionnement des ensembles ainsi réalisés. Dans les émetteurs-récepteurs radioélectriques par exemple, la proximité de la logique d'analyse des états du clavier de commande de la borne d'antenne est parfois la cause d'apparitions de signaux parasites qui altèrent le signal détecté par l'antenne à chaque instant d'analyse des états du clavier. D'autre part, pour les émetteurs portables ou portatifs alimentés en énergie électrique par des piles ou des accumulateurs, la lecture périodique des états des claviers ou des commutateurs consomment une énergie qui est non négligeable lorsque la fréquence d'analyse est élevée, ce qui limite leur durée d'utilisation.

Le but de l'invention est de pallier les inconvénients précités.

A cet effet, l'invention a pour objet, un procédé d'analyse par un microprocesseur des états d'un ensemble clavier-commutateur d'un panneau de commande consistant à déclencher dans le microprocesseur la lecture de l'état électrique de l'ensemble clavier-commutateur à chaque changement d'état d'au moins un élément de l'ensemble clavier-commutateur dès l'apparition du changement d'état caractérisé en ce qu'il consiste à placer le microprocesseur dans l'état "arrêt" non alimenté ou "d'attente" où seule l'horloge interne du microprocesseur est alimentée et à quitter cet état lorsqu'un changement d'état se produit sur le panneau.

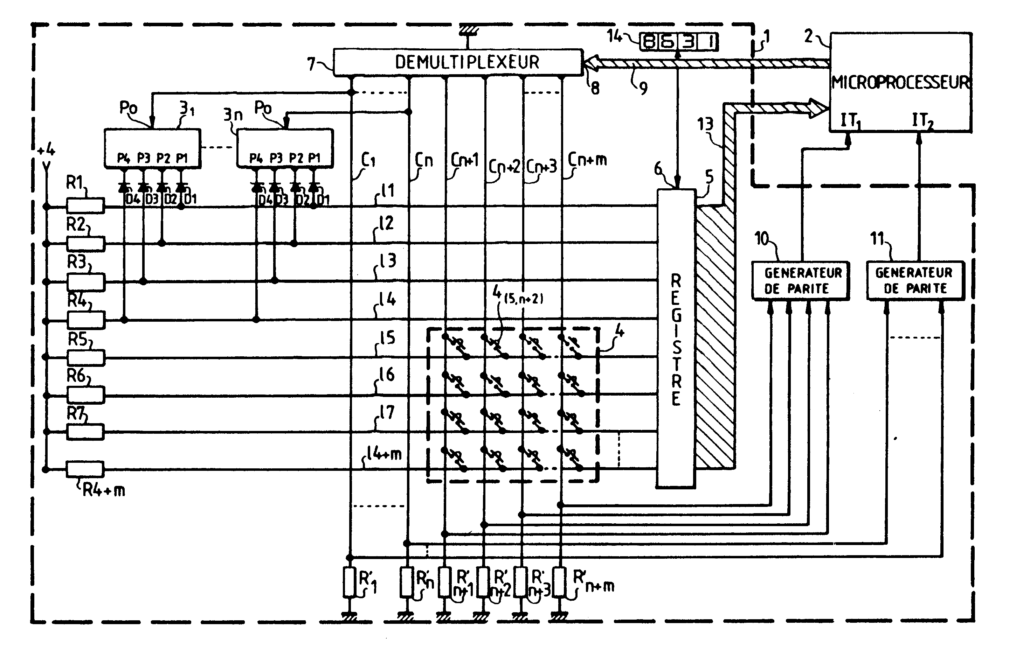

D'autres caractéristiques et avantages de l'invention apparaîtront ci-après à l'aide de la description faite en regard de la figure annexée qui représente un ensemble clavier-commutateur d'un panneau de commande d'un appareil quelconque couplé à un microprocesseur. Sur cette figure un ensemble clavier-commutateur, composant un panneau de commande, est représenté à l'intérieur d'une ligne fermée en pointillés 1, couplé à un microprocesseur 2. Le panneau se compose d'un ensemble de n commutateurs numériques BCD à 10 positions, référencés de 3₁ à 3ₙ, BCD étant l'abréviation du terme anglo-saxon "Binary coded decimal". Chaque position d'un commutateur est repérable par une combinaison binaire de 4 signaux, celle-ci apparaissant sur les sorties marquées P₁ , P₂, P₃ et P₄ des commutateurs. Les sorties P₁ à P₄ sont reliées respectivement au travers de 4 diodes, portant les références D₁ à D₄_{,} à une même ligne d'une matrice de connexion formée par n colonnes portant les références c₁ à cₙ, et 4 lignes portant les références l₁ à l₄. Ainsi les sorties P₁ sont reliées à la ligne l₁ au travers respectivement une diode D₁, les sorties P₂ sont reliées à la ligne l₂ au travers respectivement une diode D₂ et... et la sortie P₄ est reliée à la ligne l₄ au travers une diode D₄. Chaque commutateur 3₁ à 3ₙ est relié d'autre part, par une borne d'entrée Pₒ, respectivement à une colonne c₁ à cₙ de la matrice de connexion. D'une façon générale, le câblage précédent peut être étendu à celui de commutateurs possédant un nombre quelconque P de positions. La matrice de connexion comportera alors S lignes en nombre égal à celui des sorties des commutateurs, le nombre S étant tel que la relation 2^{S} > P soit vérifiée.

Le panneau comprend également une matrice de m² touches ou boutons poussoirs représentés à l'intérieur d'une ligne fermée en pointillés 4, chaque bouton poussoir étant placé au croisement 4ij d'une ligne i et d'une colonne j de la matrice 4. L'ensemble commutateur-touche ainsi formé constitue donc une matrice de l₄₊ₘ lignes référencées de l₁ ... l₄₊ₘ et de n+m colonnes référencées de c₁ ... cₙ₊ₘ . Chacune des lignes possèdent une première extrémité reliée à un potentiel +u au travers d'une résistance R portant respectivement les références R₁, R₂ ... R₄₊ₘ, sa deuxième extrémité étant reliée à une entrée d'un registre tampon 5. Chacune des colonnes c₁ à cₙ₊ₘ possède une première extrémité reliée à une sortie d'un démultiplexeur 7 à n+m sorties et une deuxième extrémité qui est reliée au circuit de masse formant la référence des potentiels des circuits représentés sur la figure, au travers d'une résistance R′, les résistances R′ portant sur la figure les références R′₁ à R′ₙ₊ₘ.

Le démultiplexeur 7 est relié sur ses entrées de commande 8 à un bus d'adresses 9 du microprocesseur 2. Chaque colonne de la matrice de touche 4 est reliée à un générateur de parité 10 et chaque colonne c₁ à cₙ de la matrice de commutateur est reliée à un générateur de parité 11. Les signaux qui transitent sur les lignes de la matrice transitent dans le registre tampon 5 avant d'être appliqués sur le bus de données 13 du microprocesseur 2. Les sorties des générateurs de parité 10 et 11 sont reliées respectivement à des entrées d'interruption IT₁ et IT₂ du microprocesseur 2.

Le fonctionnement est décrit ci-après suivant un premier mode où le microprocesseur 2 est en "attente" d'un changement d'état d'au moins un élément du tableau de commande et suivant un deuxième mode où un changement d'état intervient.

Suivant le premier mode de fonctionnement qui peut encore être appelé mode "attente" ou "STAND BY" dans le langage anglo-saxon, les lignes de la matrice de touches sont placées à l'état 1 et les colonnes sont placées dans l'état 0. Les sorties du démultiplexeur 7 sont dans l'état haute impédance et aucun courant ne circule dans les résistances R′ placées au pied des colonnes de la matrice. Par contre dans l'état stable des commutateurs, il existe toujours au moins une connexion entre une colonne c₁ ... cₙ et une ligne l₁ ... l₄ de la matrice de connexion, et un courant circule dans chaque diviseur potentiométrique formé par les résistances R et R′ reliées aux lignes et aux colonnes de la matrice de connexion, ce qui fait apparaître des tensions aux bornes de chaque résistance R′ correspondante. Les générateurs de parité 10 et 11 reflètent naturellement l'état stable qui est ainsi obtenu et le microprocesseur 2 qui n'est pas sollicité reste dans un mode de fonctionnement où il ne consomme que très peu d'énergie. Le mode "attente" ou "STAND BY" peut être assuré par les fonctions "attente" ou "WAIT" ou encore "arrêt" ou "STOP" communs à tous les microprocesseurs. Dans la fonction "arrêt" ou "STOP" toute horloge est inhibée et la consommation en courant est très faible. En contrepartie, le temps de réveil de certain microprocesseur est relativement long de l'ordre de 100 millisecondes, de sorte que pour certaines applications les modes "arrêt" ou "STOP" peuvent apparaître incompatibles avec la saisie sous interruption d'un appui touche. Par contre, dans les modes "attente" ou "WAIT" dans lesquels seule l'horloge du microprocesseur est activée, la consommation en courant reste encore très faible et le temps de réveil qui est de l'ordre de quelques microsecondes apparaît alors tout à fait acceptable pour la majorité des applications où le procédé et le dispositif de l'invention seront employés.

Le microprocesseur 2 quitte l'état "attente" ou "STAND BY" dès qu'une touche ou qu'un changement d'état intervient sur un commutateur du panneau de commande.

Une touche enfoncée produit un court-circuit au croisement de la ligne et de la colonne de la matrice qui lui correspond. Ce court-circuit porte à un potentiel haut la colonne correspondante grâce au courant qui circule dans le diviseur potentiométrique formé par les résistances R et R′ placées aux extrémités de la ligne et de la colonne ainsi court-circuitée. Ceci produit un changement d'état des entrées du générateur de parité 10 qui modifie alors son état de sortie et provoque l'application d'un signal d'interruption sur l'entrée IT₁ du microprocesseur 2.

Dans le cas des commutateurs, le passage d'une position à une autre provoque l'ouverture des contacts lignes et colonnes et porte le potentiel de la colonne correspondante liée au commutateur sur lequel a lieu le changement d'état, à l'état 0 volt, ce qui modifie l'état de la sortie du générateur de parité 11 qui applique un signal d'interruption sur l'entrée de commande d'interruption IT₂ du microprocesseur 2. A ce stade du fonctionnement les diodes D₁ à D₄ intercalées entre chaque contact d'un commutateur et sa ligne associée permettent d'éviter les courts-circuits ligne à ligne lorsque se produit un changement d'état sur un commutateur.

Une fois l'appui-touche ou la manipulation d'un commutateur détecté le microprocesseur 2 lance une séquence de temporisation anti-rebond, et à la fin de cette séquence, il procède à la lecture de l'ensemble des colonnes de la matrice commutateur ou clavier. Dans ce mode opératoire chaque colonne de la matrice est considérée par le microprocesseur comme un registre. De la sorte une simple instruction de lecture en langage assembleur permet la sélection à la fois d'une colonne (spécifiée dans l'adresse de l'instruction assembleur et du registre tampon 5. Le code correspondant à cette colonne est alors directement appliqué par l'intermédiaire du registre tampon 5 sur le bus de donnée 13. De cette façon la lecture des codes générés se traduit au niveau du microprocesseur par l'exécution d'une série d'instructions, dont le libellé peut être :
"lecture de m registres pour le clavier ou de n registres pour les commutateurs".

Dans l'exécution de cette instruction, la sélection d'une colonne quelconque est obtenue par l'application par les sorties du démultiplexeur 7 d'un potentiel 0 volt sur la colonne. L'état électrique des lignes qui est alors obtenu reflétant l'état des touches ou du commutateur situés sur cette colonne.

La donnée obtenue lors de la lecture d'une colonne de la matrice est constituée par deux zones binaires, une première zone correspondant aux lignes de la matrice clavier et une deuxième zone correspondant à celle de la matrice commutateur.

Comme chaque commutateur possède 4 sorties l'état d'un commutateur qui est ainsi lu est compris entre 0 et 14. Chaque code lu, pour mesurer l'état du clavier, correspond dans le cas d'un simple appui d'une touche à un nombre de la suite 1, 2, 4, 8 etc 2^{m}. Cependant un algorithme judicieux pourra toujours permettre la détection de double appuis-touches.

La détection séparée des actions clavier et commutateur a l'avantage qu'elle permet de gérer des anti-rebonds différents et d'assurer un confort optimal à l'utilisateur dans ces différentes manipulations. Pour les commutateurs des temporisations anti-rebonds comprises entre 100 et 250 millisecondes pourront être choisies et des temporisations anti-rebonds touche-clavier compris entre 10 à 20 millisecondes seront suffisantes.

Toutefois, le dispositif décrit peut présenter quelques limitations qui sont dues au principe de détection qui est mis en oeuvre. En effet, comme les colonnes de la matrice sont directement reliées au générateur de parité tout changement d'état sur celles-ci provoque une interruption. En particulier la sélection d'une colonne lors de l'adressage de la matrice se traduit par le passage à 0 de cette colonne et crée donc une impulsion à la sortie du générateur de parité correspondant. Dans ces conditions, il faut invalider lors de la lecture les entrées d'interruption correspondantes, ce qui crée une zone d'ombre où toute action de l'opérateur sur les organes d'exploitation correspondant à la matrice lue est ignorée. La durée de cette zone est directement liée à la vitesse de l'algorithme de lecture. Si un commutateur change d'état pendant cette zone d'ombre il n'y aura pas d'interruption au niveau du microprocesseur et la lecture en cours sera considérée comme bonne malgré qu'elle ne reflète plus la position réelle du commutateur. Par contre, pour une touche, ce cas d'espèce sera interprété comme un double appui et la non détection de d'un appui-touche n'est pas gênante. Dans le cas des commutateurs l'inconvénient précité pourra être pallié en utilisant un commutateur disposant d'une piste supplémentaire dédiée à la détection des changements d'état. On notera cependant, que de par le principe de l'invention, la lecture qui est effectuée est très rapide et qu'elle réduit considérablement la largeur de la zone d'ombre. La perte de l'information de changement d'état d'un commutateur apparaît de ce fait peu probable d'autant plus que ce changement d'état s'accompagne de rebonds non négligeables.

On notera également que suivant d'autres modes de réalisation de panneaux de commande, mettant en oeuvre les principes de l'invention, l'assimilation dans le mode lecture des colonnes de l'organisation matricielle des organes du tableau à de simples registres microprocesseurs peut aussi être faite en mode écriture, ce pourra être le cas par exemple, du multiplexage d'un organe de visualisation, comportant un nombre de caractère quelconque, situé sur le tableau du type de celui représenté en 14 sur la figure. Dans ce cas chaque caractère peut s'identifier à un simple registre accessible en écriture seulement. On obtient ainsi des cycles d'écriture extrêmement courts et par la même on réduit comme dans le cas de la lecture la consommation du microprocesseur.

## Revendications

1. Procédé d'analyse par un microprocesseur (2) des états d'un ensemble clavier (4)-commutateur (3) d'un panneau de commande (1) consistant à déclencher (IT₁, IT₂) dans le microprocesseur (2) la lecture de l'état électrique de l'ensemble clavier (4)-commutateur (3) à chaque changement d'état d'au moins un élément de l'ensemble clavier-commutateur dès l'apparition du changement d'état caractérisé en ce qu'il consiste à placer le microprocesseur (2) dans l'état "arrêt" non alimenté ou "d'attente" où seule l'horloge interne du microprocesseur est alimentée, et à quitter cet état lorsqu'un changement d'état se produit sur le panneau (1).

2. Procédé selon la revendication 1 caractérisé en ce que chaque changement d'état d'un élément du panneau (1) provoque le déclenchement d'une séquence de temporisation avant la lecture de l'ensemble des états des éléments du panneau (1).

3. Procédé selon les revendications 1 et 2 caractérisé en ce que l'ensemble clavier (4)-commutateur (3) comprend des contacts disposés chacun au croisement d'une ligne (lᵢ) et d'une colonne (cᵢ) d'une matrice, et en ce que les états des contacts de chaque colonne sont lus successivement colonne par colonne.

4. Procédé selon la revendication 1, caractérisé en ce que la lecture des états de chaque colonne (cᵢ) de contact est obtenue par l'exécution d'une simple instruction de lecture de registre.

5. Dispositif pour la mise en oeuvre du procédé d'analyse selon la revendication 1, comprenant un microprocesseur (2) et un ensemble clavier (4)-commutateurs (3) d'un panneau de commande caractérisé en ce qu'il comprend au moins un générateur de parité (10, 11) interposé entre l'ensemble clavier-commutateur et le microprocesseur (2) pour détecter tout changement d'état intervenant dans l'ensemble clavier-commutateur et provoquer une interruption du microprocesseur (2) lorsqu'un changement d'état intervient afin que le microprocesseur (2) quitte l'état "arrêt" non alimenté ou "d'attente" avec seulement l'horloge du microprocesseur alimenté.

6. Dispositif selon la revendication 5 caractérisé en ce que le clavier (4) comporte des touches (4ij) dont les contacts sont situés aux croisements de lignes et de colonnes de la matrice.

7. Dispositif selon la revendication 5 caractérisé en ce que les commutateurs (3) comportent P positions qui sont codées en binaire sur S sorties, les S sorties étant couplées à S lignes de la matrice, et en ce qu'il possède également une entrée (Pₒ) reliée chacun à une colonne de la matrice.

8. Dispositif selon les revendications 6 et 7 caractérisé en ce que chaque colonne (cᵢ) est adressée par le microprocesseur (2) au travers d'un démultiplexeur (7).

9. Dispositif selon l'une quelconque des revendications 6 à 8 caractérisé en ce que les lignes (lᵢ) de la matrice sont reliées au dit générateur de parité (10, 11) pour détecter tout changement d'état intervenant dans les contacts situés au croisement des lignes et des colonnes de la matrice.

10. Dispositif selon la revendication 9 caractérisé en ce que chaque générateur de parité (10, 11) provoque une interruption (IT₁, IT₂) du microprocesseur lorsqu'un changement d'état intervient.

11. Dispositif selon les revendications 6 à 10 caractérisé en ce que le panneau (1) comporte au plus un organe de visualisation (14) dont chaque caractère est modifiable en écriture seulement par simple exécution d'une instruction d'écriture de registre du microprocesseur.

## Claims

1. Method for analysis by a microprocessor (2) of the states of a keyboard (4)-changeover switch (3) assembly of a control panel (1) consisting in triggering (IT₁, IT₂), in the microprocessor (2), the reading of the electrical state of the keyboard (4)-changeover switch (3) assembly on each change of state of at least one element of the keyboard-changeover switch assembly upon the appearance of the state change, characterised in that it consists in placing the microprocessor (2) in the power-off "stop" or "standby" state in which only the internal clock of the microprocessor is powered, and in quitting this state when a state change takes place on the panel (1).

2. Method according to Claim 1, characterised in that each change of state by an element of the panel (1) gives rise to the triggering of a time delay sequence before the reading of all of the states of the elements of the panel (1).

3. Method according to Claims 1 and 2, characterised in that the keyboard (4)-changeover switch (3) assembly comprises contacts each arranged at the intersection of a line (lᵢ) and of a column (cᵢ) of a matrix, and in that the states of the contacts of each column are read successively column by column.

4. Method according to Claim 1, characterised in that the reading of the states of each contact column (cᵢ) is obtained by executing a single register read instruction.

5. Device for implementing the analysis method according to Claim 1, comprising a microprocessor (2) and a keyboard (4)- changeover switches (3) assembly of a control panel, characterised in that it comprises at least one parity generator (10, 11), interposed between the keyboard-changeover switch assembly and the microprocessor (2), for detecting any state change occurring in the keyboard-changeover switch assembly and bringing about interruption of the microprocessor (2) when a state change occurs so that the microprocessor (2) quits the power-off "stop" or "standby" state with only the clock of the microprocessor powered.

6. Device according to Claim 5, characterised in that the keyboard (4) includes keys (4ij) whose contacts are situated at the intersections of lines and of columns of the matrix.

7. Device according to Claim 5, characterised in that the changeover switches (3) include P positions which are binary coded on S outputs, the S outputs being coupled to S lines of the matrix, and in that it also possesses an input (Pₒ) each linked to one column of the matrix.

8. Device according to Claims 6 and 7, characterised in that each column (c₁) is addressed by the microprocessor (2) through a demultiplexer (7).

9. Device according to any one of Claims 6 to 8, characterised in that the lines (lᵢ) of the matrix are linked to the said parity generator (10, 11) in order to detect any state change occurring in the contacts situated at the intersection of the lines and of the columns of the matrix.

10. Device according to Claim 9, characterised in that each parity generator (10, 11) gives rise to an interruption (IT₁, IT₂) of the microprocessor when a state change occurs.

11. Device according to Claims 6 to 10, characterised in that the panel (1) includes at most one visual display unit (14) each character of which can be modified in writing merely by simple execution of a register write instruction from the microprocessor.

## Patentansprüche

1. Mittels eines Mikroprozessors (2) durchgeführtes Verfahren zum Analysieren der Zustände einer Tastatur(4)-Schalter-(3)-Baueinheit einer Steuertafel (1), das darin besteht, in den Mikroprozessor (2) das Lesen des elektrischen Zustandes der Tastatur(4)-Schalter(3)-Baueinheit bei jeder Zustandsänderung wenigstens eines Elements der Tastatur-Schalter-Baueinheit seit dem Auftreten der Zustandsänderung auszulösen, dadurch gekennzeichnet, daß es darin besteht, daß der Mikroprozessor (2) in den nicht versorgten "Anhaltezustand" oder in den "Wartezustand", in dem nur der interne Taktgeber des Mikroprozessors versorgt wird, versetzt wird, und daß dieser Zustand verlassen wird, wenn eine Zustandsänderung an der Tafel (1) auftritt.

2. Verfahren nach Anspruch 1, dadurch gekennzeichnet, daß jede Zustandsänderung eines Elements der Tafel (1) durch Auslösen einer Verzögerungssequenz vor dem Lesen der Gesamtheit der Zustände der Elemente der Tafel (1) auslöst.

3. Verfahren nach Anspruch 1 und 2, dadurch gekennzeichnet, daß die Tastatur(4)-Schalter(3)-Baueinheit Kontakte enthält, die jeweils am Überkreuzungspunkt einer Zeile (l₁) und einer Spalte (c₁) einer Matrix angeordnet sind, und daß die Zustände der Kontakte jeder Spalte nacheinander Spalte für Spalte gelesen werden.

4. Verfahren nach Anspruch 1, dadurch gekennzeichnet, daß das Lesen der Zustände jeder Kontaktspalte (c₁) durch Ausführen eines einfachen Registerlesebefehls erhalten wird.

5. Anordnung zur Durchführung eines Analyseverfahrens nach Anspruch 1 mit einem Mikroprozessor (2) und einer Tastatur(4)-Schalter(3)-Baueinheit einer Steuertafel, gekennzeichnet durch wenigstens einen Paritätsgenerator (10, 11), der zwischen die Tastatur-Schalter-Baueinheit und den Mikroprozessor (2) eingefügt ist, um jede Zustandsänderung zu erfassen, die in der Tastatur-Schalter-Baueinheit vorkommt und um eine Unterbrechung des Mikroprozessors (2) hervorzurufen, wenn eine Zustandsänderung eintritt, damit der Mikroprozessor (2) den nicht versorgten "Anhaltezustand" oder den "Wartezustand", in dem nur der Taktgeber des Mikroprozessors versorgt wird, verläßt.

6. Anordnung nach Anspruch 5, dadurch gekennzeichnet, daß die Tastatur (4) Tasten (4ij) enthält, deren Kontakte an Kreuzungspunkten von Leitungen und Spalten der Matrix liegen.

7. Anordnung nach Anspruch 5, dadurch gekennzeichnet, daß die Schalter (3) P-Positionen haben, die binär an S-Ausgängen codiert sind, wobei die S-Ausgänge mit S-Zeilen der Matrix gekoppelt sind, und daß sie auch einen Eingang (Pₒ) aufweist, der jeweils mit einer Spalte der Matrix verbunden ist.

8. Anordnung nach den Ansprüchen 6 und 7, dadurch gekennzeichnet, daß jede Spalte (cᵢ) vom Mikroprozessor (2) über einen Demultiplexer (7) adressiert wird.

9. Anordnung nach einem der Ansprüche 6 bis 8, dadurch gekennzeichnet, daß die Zeilen (lᵢ) der Matrix an den Paritätsgenerator (10, 11) angeschlossen sind, damit jede Zustandsänderung erfaßt wird, die an den Kontakten erfolgt, die an Überkreuzungspunkten der Zeilen und der Spalten der Matrix liegen.

10. Anordnung nach Anspruch 9, dadurch gekennzeichnet, daß jeder Paritätsgenerator (10, 11) eine Unterbrechung (IT₁, IT₂) des Mikroprozessors hervorruft, wenn eine Zustandsänderung eintritt.

11. Anordnung nach den Ansprüchen 6 bis 10, dadurch gekennzeichnet, daß die Tafel (1) wenigstens ein Anzeigeorgan (14) enthält, bei dem jedes Zeichen nur beim Schreiben durch einfaches Ausführen eines Registerschreibbefehls des Mikroprozessors geändert werden kann.
